# EUROPÄISCHE PATENTANMELDUNG

(11) **EP 0 737 657 A2**
(43) Veröffentlichungstag der Anmeldung: **16.10.1996**
(21) Anmeldenummer: 96104704.0
(22) Anmeldetag: 25.03.1996
(51) Int. Cl.: C04B 41/88

(54) **Verfahren zur Herstellung eines metallbeschichteten, metallisierten Bauteils aus Aluminiumnitridkeramik und damit erhaltenes metallbeschichtetes Bauteil**

(30) Priorität: 13.04.1995 DE 19514018
(71) Anmelder: Hoechst CeramTec Aktiengesellschaft, 95100 Selb (DE)
(72) Erfinder: Thimm, Alfred, Dr., D-95632 Wunsiedel (DE)
(74) Vertreter: Kachholz, Traudel

(57) **Zusammenfassung**

Die Erfindung betrifft ein Verfahren zur Herstellung eines metallbeschichteten, metallisierten Bauteils aus Aluminiumnitridkeramik in den Schritten:
- Zubereitung einer Metallisierungspaste, enthaltend ein pulvriges Glas des MnO-Al₂O₃-SiO₂-Systems und ein Refraktärmetallpulver,
- Auftragen der Metallisierungspaste auf die Bauteiloberfläche,
- Ausbrennen des mit Metallisierungspaste beschichteten Bauteils bei einer Temperatur > 1100 °C unter reduzierter Feuchtgasatmosphäre aus wasserstoffhaltigem Stickstoff,
- Metallbeschichtung des metallisierten Bauteils mittels Galvanisierung,
das dadurch gekennzeichnet ist, daß während des Aufheizens des mit Metallisierungspaste beschichteten keramischen Bauteils die Atmosphäre mit Wasserdampf so angefeuchtet wird, daß der Wasserdampfgehalt im Temperaturintervall zwischen 800 °C und 1050 °C einem Taupunkt von > 295 K entspricht und der Wasserdampfgehalt außerhalb dieses Temperaturintervalls einem Taupunkt <295 K.
Die Erfindung betrifft auch eine Metallisierungspaste, die einen Haftvermittler aus Glaspulver mit einer mittleren Korngröße von 2 - 15 µm, ein Refraktärmetallpulver mit einer mittleren Korngröße von 1-4 µm sowie ein in einem geeigneten Lösungsmittel gelöstes organisches Harz oder/und ein Siebdrucköl enthält und die für das Auftragen auf das Bauteil mittels Siebdrucktechnik eine Viskosität von 50 - 100 Pa · s und für das Auftragen durch Eintauchen eine Viskosität von < 5 Pa · s aufweist.

## Beschreibung

Die vorliegende Erfindung betrifft ein Verfahren zur Herstellung eines metallbeschichteten, metallisierten Bauteils aus Aluminiumnitridkeramik, eine Metallisierungspaste zur Durchführung des Verfahrens sowie das damit erhaltene metallbeschichtete Bauteil.

In der Elektronik ist es Stand der Technik, Bauteile aus keramischen Werkstoffen, welche hauptsächlich Aluminiumoxid oder Aluminiumnitrid enthalten, mit hochschmelzenden Metallen zu metallisieren und diese metallisierten Bauteile sodann durch Aufbringen weiterer Metallschichten weiter zu verstärken. Auf diese obersten Metallschichten können dann z. B. bei der Herstellung elektronischer Schaltungen weitere Bauelemente wie Dioden, Widerstände und dergleichen mit Hilfe von Weichloten aufgebracht werden. Als hochschmelzende Metalle (Refraktärmetalle) werden vorzugsweise Wolfram und Molybdän verwendet. Die obersten Metallschichten können sodann auf die metallisierten Bauteile, vorzugsweise mittels galvanischer Verfahren, abgeschieden werden.

In der Mikroelektronik finden Aluminiumnitrid-Bauteile, insbesondere Substrate, wegen ihrer hochwärmeleitfähigen Eigenschaften bevorzugte Verwendung. Hierzu wird dem Aluminiumnitrid-Pulver vor dem Brennen keine SiO₂-haltige Glasphase als Sinterhilfe zugegeben, wie das bei der Herstellung von Aluminiumoxid-Bauteilen bekannt ist. Andererseits ist im Stand der Technik bekannt, daß eine haftfeste Metallisierung mit hochschmelzenden Metallen wie Wolfram oder Molybdän nur möglich ist, wenn bestimmte Anteile an SiO₂-haltiger Glasphase (mindestens 1,5 Gew.-%) in der gebrannten Keramik vorhanden sind (Bronnes, R. L., Die Herstellung gelöteter Keramik-Metallverbindungen mit Kathodenzerstäubung als Metallisierungstechnik, Philips Technische Rundschau 35, 227 (1975) und Cooper, D., The Development of High Quality Alumina Substrates, Industrial Ceramics 9, 115 (1989)). Ist der Anteil der Glasphase zu gering, kann alternativ auch ein Glaszusatz der Metallisierungspaste beigemengt werden (Fulrath, R. M., Ceramic Bulletin 47, 493 (1968)). Bei Verwendung von Bauteilen aus Aluminiumnitridkeramik ist jedoch zu beachten, daß Aluminiumnitrid gegenüber vielen oxidischen Verbindungen wie beispielsweise ZnO, PbO, Bi₂, O₃, B₂, O₃ thermodynamisch instabil ist. Eine Herabsetzung der freien Enthalpie wird erreicht, indem in einer Festkörperreaktion Aluminiumoxid, Metall und Stickstoff gebildet werden. Diese Reaktion hat zur Folge, daß der Teilchenverbund in der Keramik zerstört wird, wodurch die Festigkeit sinkt (Kageyama, M., IMC Proceedings 1988, 161 (1988)) und Kubota, T., IMC Proceedings 1988, 137 (1988)). Hingegen gilt Siliziumdioxid gegenüber Aluminiumnitrid als indifferent.

Zur Erhöhung der Haftfestigkeit zwischen Metallisierungsschicht und dem keramischen Bauteil wurden im Stand der Technik Substanzen eingesetzt, wie beispielsweise TiN, Ti, CaO, Al₂O₃, Si, SiO₂, Al, Ta, Cr, welche auf der Oberfläche des Aluminiumnitrids kristalline Phasen ausbilden und somit gut haften (EP 0 433 992 Al, EP 0 305 295 Bl, EP 0 276 788 Bl, US 5,063,121 und US 4,840,853). Derartige pulverförmige Zusätze sind aber sehr teuer wie beispielsweise Tantal, Titan, Titannitrid oder die Korngröße des Pulvers ist nur sehr schwer einstellbar, wie beispielsweise beim Aluminium. Die Einbrenntemperaturen bei derartigen Beimengungen liegen üblicherweise bei 1500 - 1700 °C und sind damit außerordentlich hoch.

Der vorliegenden Erfindung liegt daher die Aufgabe zugrunde, ein Verfahren zur Verfügung zu stellen, mit welchem keramische Aluminiumnitrid-Bauteile relativ einfach und preiswert metallisiert werden können, wobei die Zerstörung des Gefüges des Aluminiumnitridbauteils vermieden wird und eine hohe Haftfestigkeit erzielt werden kann.

Die Aufgabe wird erfindungsgemäß gelöst mit einem Verfahren zur Herstellung eines metallbeschichteten, metallisierten Bauteils aus Aluminiumnitridkeramik in den Schritten:
- Zubereitung einer Metallisierungspaste, enthaltend ein pulvriges Glas des MnO-Al₂O₃-SiO₂-Systems und ein Refraktärmetallpulver,
- Auftragen der Metallisierungspaste auf die Bauteiloberfläche,
- Ausbrennen des mit Metallisierungspaste beschichteten Bauteils bei einer Temperatur > 1100 °C unter reduzierter Feuchtgasatmosphäre aus wasserstoffhaltigem Stickstoff,
- Metallbeschichtung des metallisierten Bauteils mittels Galvanisierung,
dadurch gekennzeichnet, daß während des Aufheizens des mit Metallisierungspaste beschichteten keramischen Bauteils die Atmosphäre mit Wasserdampf so angefeuchtet wird, daß der Wasserdampfgehalt im Temperaturintervall zwischen 800 °C und 1050 °C einem Taupunkt von > 295 K entspricht und der Wasserdampfgehalt außerhalb dieses Temperaturintervalls einem Taupunkt von < 295 K entspricht.

Die Aufgabe wird ferner erfindungsgemäß gelöst mit einer Metallisierungspaste zur Durchführung dieses Verfahrens, wobei die Metallisierungspaste einen Haftvermittler aus Glaspulver mit einer mittleren Korngröße von 2 - 15 µm, ein Refraktärmetallpulver mit einer mittleren Korngröße von 1-4 µm sowie ein in einem geeigneten Lösungsmittel gelöstes organisches Harz oder/und ein Siebdrucköl enthält und wobei sie für das Auftragen auf das Bauteil mittels Siebdrucktechnik eine Viskosität von 50 - 100 Pa · s und für das Auftragen durch Eintauchen eine Viskosität von < 5 Pa · s aufweist.

Außerdem wird die Aufgabe erfindungsgemäß mit einem mit dieser Metallisierungspaste metallisierten Bauteil aus Aluminiumnitrid mit aufgalvanisierten Metallschichten gelöst, das entsprechend hergestellt ist, bei dem die aufgetragenen Metallschichten eine Haftfestigkeit aufweisen, welche durch mittlere Abreißwerte von ≧ 3,5 kN/cm² gekennzeichnet sind.

Die Verwendung eines glasartigen Haftvermittlers, basierend auf dem System MnO/Al₂O₃/SiO₂ neben dem Metallpulver, insbesondere Wolfram und/oder Molybdän, zur Metallisierung eines keramischen Bauteils ist im Prinzip aus der EP 0 265 231 B1 bekannt. Dort werden jedoch keine keramischen Bauteile aus Aluminiumnitrid metallisiert, aufgrund des bekannten Problems, daß glasartige Haftvermittler das Aluminiumnitridbauteil beim Aufschmelzen nur ungenügend benetzen und Blasen werfen (IMC Proceedings 1988, 137 (1988)).
Erfindungsgemäß wurde überraschend gefunden, daß beim Einbrennprozeß der Metallisierungspaste die darauf aufgalvanisierte Metallisierungsschicht dann auf dem Aluminiumnitrid-Bauteil fest haften bleibt, wenn eine definierte Temperaturführung in Verbindung mit einem definierten Feuchtigkeitsgehalt des reduzierend wirkenden Schutzgases gemäß den kennzeichnenden Merkmalen des Beispiels 1 während des Aufheizens eingehalten wird.

Die Verwendung des Manganoxid-Aluminiuinoxid-Siliciumdioxid-Systems als Haftvermittler bietet gegenüber anderen Gläsern, wie beispielsweise solchen auf Basis von Calciumsilicat den Vorteil, daß sie schon bei etwa 1400 °C genügend weich sind, um sich auf dem keramischen Bauteil auszubreiten, ohne jedoch so dünnflüssig zu sein, daß sie auseinanderfließen und das Druckbild der beispielsweise mittels Siebdruckverfahrens aufgetragenen Metallisierungspaste verbreitern. Die Zusammensetzung des glasartigen Haftvermittlers beträgt vorzugsweise 30 - 50 Gew.-% MnO, 3 - 15 Gew.-% Al₂O₃, 30 - 60 Gew.-% SiO₂, wobei besonders bevorzugt, noch bis zu 2 Gew.-% TiO₂ zugegeben werden. Essentiell für die gute Haftung ist das Titandioxid jedoch nicht, diese ist vielmehr auf die spezielle Temperaturführung zurückzuführen. CaO, MgO, BaO, Fe₂O₃, Na₂O können allein oder in beliebiger Kombination miteinander mit insgesamt bis zu 4 Gew.-% zugegen sein.

Die Herstellung der entsprechenden Metallisierungspaste erfolgt so, daß handelsübliches Glaspulver mit einer mittleren Korngröße von ca. 70 µm in einer Keramikzylinder enthaltenden Kugelmühle mit Wasser aufgemahlen und auf eine mittlere Korngröße von 2 - 15 µm, vorzugsweise 7 - 9 µm, eingestellt wird. Sodann werden 5 - 30 Gew.-% dieses getrockneten Glaspulvers, vorzugsweise 15 Gew.-%, mit 70 - 95 Gew.-%, vorzugsweise 85 Gew.-% Refraktärmetallpulvers, vorzugsweise Wolfram- und/oder Molybdänpulver vermengt, wobei das Metallpulver eine mittlere Korngröße von vorzugsweise 1 - 4 µm aufweisen und im wesentlichen oder gänzlich aus diesem Metall bestehen soll. Es kann eine Metallisierungspaste verwendet werden, deren Gewichtsverhältnis von Glaspulver zu Metallpulver 1 : 19 bis 6 : 14, insbesondere 1 : 9 bis 4 : 17 beträgt.

Unter Zugabe eines in einem Lösungsmittel, wie beispielsweise Terpineol, gelösten organischen Harzes, beispielsweise ein Polyvinylbutyral oder ein Acrylharz, oder auch eines käuflichen Siebdrucköls (Firma Reusche) beispielsweise in Terpineol gelöste Ethylcellulose, wird eine Paste hergestellt, die eine für die weitere Verarbeitung geeignete Viskosität aufweisen soll. Wird die Paste mittels Siebdrucktechnik auf die Bauteiloberfläche aufgetragen, ist eine Viskosität von 50 - 100 Pa · s durch Zugabe geeigneter Mengen an Siebdrucköl anzustreben. Soll dagegen ein geometrisch kompliziert gebauter Körper aus Aluminiumnitridkeramik metallisiert werden, kann man den Körper in eine Paste mit einer Viskosität von beispielsweise unter 5 Pa · s tauchen. Die Qualität des Druckbildes beim Siebdruckverfahren läßt sich durch die Auswahl der Öle beeinflussen. Eine Zugabe von 0, 1 bis 5 % von Polyvinylbutyral (PVB) zu einem Siebdrucköl erlaubt beispielsweise den Druck feiner Strukturen von etwa 100 µm Breite, indem es das Fließverhalten der Paste reduziert und ein Auseinanderfließen feiner Strukturen verhindert. Die Dicke der aufgetragenen Metallisierungspastenschicht kann 10 bis 50 µm, insbesondere 20 bis 25 µm betragen.

Der Einbrand der Metallisierungspaste erfolgt unter einem reduzierend wirkenden wasserdampfhaltigen Schutzgas, wie beispielsweise Stickstoff.

Vorzugsweise wird eine Mischung von 75 % Stickstoff und 25 % Wasserstoff verwendet. Der Einbrand erfolgt bei Temperaturen von 1100 - 1600 °C, vorzugsweise bei 1400 °C - 1420 °C. Die Haltezeit des mit Metallisierungspaste beschichteten keramischen Aluminiunnitridbauteils beträgt bei der Spitzentemperatur 30 - 120 Minuten, vorzugsweise 55 - 65 Minuten. Aluminiumnitridsubstrate für die Verwendung in integrierten Schaltkreisen weisen gewöhnlich Dicken von 0,5 - 0,63 mm auf.

Erfindungsgemäß wird beim Aufheizen im Temperaturintervall zwischen 800 °C und 1050 °C der Schutzgasatmosphäre soviel Wasserdampf zugesetzt, daß der Gehalt an Wasserdampf einem Taupunkt > 295 K entspricht. Dies kann dadurch geschehen, daß man zumindest einen Teil der in den Ofen strömenden Gase durch warmes Wasser mit einer regelbaren Temperatur leitet.
Praktischerweise sollte die Zeit zum Durchlaufen dieses Temperaturintervalls zwischen 50 und 150 min., vorzugsweise 100 min. betragen. Die Zeit hat jedoch keinen Einfluß auf die Haftfestigkeit der Metallisierung. Unterhalb von 800 °C und oberhalb von 1050 °C soll der Wasserdampfgehalt des in den Ofen einströmenden Gasgemisches einem Taupunkt < 295 K entsprechen, vorzugsweise einem Taupunkt von 260 - 270 K.

Elektronenmikroskopische Untersuchungen zeigten, daß nach dem so erfolgten Aufbrennen der Metallisierungspaste keine Zerstörungen im Gefüge des Aluminiumnitridbauteils feststellbar waren.

Anschließend werden die metallisierten Bauteile weiter mit üblichen galvanischen Verfahren, beispielsweise stromlos oder kathodisch, weiter beschichtet. Vorzugsweise wird zunächst eine Nickelschicht in einer Stärke von 1 - 5 µm aufgalvanisiert, gefolgt von einer Schicht aus Gold in einer Schichtdicke von etwa 0,1 - 1,5 µm. Wird das Gold kathodisch abgeschieden, kann die Schichtdicke auch größer sein. Anstelle des Goldes kann auch eine Lotschicht aus Blei-Zinn kathodisch abgeschieden werden.

Mit dem erfindungsgemäßen Verfahren lassen sich relativ einfach und kostengünstig Metallschichten mit großer Haftfestigkeit auf Aluminiumnitridbauteile aufbringen. Die verwendete Metallisierungspaste ist gleichgut auch für Aluminiumoxid-Bauteile verwendbar. Die Bauteile können Substrate zur Aufnahme von Chips und jegliche andere Arten Bauteile aus den genannten Werkstoffen sein, insbesondere sonstige Leistungsmodule, Konstruktionselemente z.B. für Leistungshalbleiter, Thyristoren, Widerstandsheizelemente, Kühlelemente, Wärmetauscher.

Die Erfindung wird nun anhand der folgenden Beispiele näher erläutert.

Die Bestimmung der Haftfestigkeit erfolgt so, daß vernickelte Muttern mit einem Kupferkern mit Hilfe eine Weichlotes, beispielsweise mit Sn63Pb37, unter einem reduzierend wirkenden Schutzgas in einem Lötofen auf beide Seiten eines mit Metall beschichteten Subtrats gelötet werden. Zur Fixierung der Anordnung kann eine Form, z. B. ans Al, eingesetzt werden. Sodann werden die Muttern mit einer Kraftmeßmaschine abgezogen, und als Abreißwert dient dann die Kraft pro Quadratzentimeter, welche aufgewendet werden muß, um die Metallschicht vom Bauteil abzuziehen.

### Beispiel 1

Auf ein gebranntes Substrat aus Aluminiumnitridkeramik einer Korngröße zwischen 4 - 8 µm mit 3 Gew.-Yttriumoxid als Sinterhilfe wurde mittels des Siebdruckverfahrens eine Metallisierungspaste in einer Stärke von 22 µm aufgetragen. Die Metallisierungspaste enthielt 68 Gew.-% Wolframpulver, 13 Gew.-% eines Glaspulvers und 19 Gew.-% eines Siebdrucköls. Das Glas setzte sich aus 7,4 Gew.- Al₂O₃, 36,3 Gew.-% MnO, 51,7 Gew. - SiO₂, 0,9 Gew.-% TiO₂, Rest CaO, MgO, BaO, Fe₂O₃, Na₂O zusammen. Als Siebdrucköl diente in Terpineol gelöste Ethylcellulose. Die Korngröße des Wolframpulvers betrug 4 µm, die Korngröße des Glaspulvers 8 µm. Die Metallisierungspaste wies eine Viskosität von 80 Pa · s auf.

Die auf das keramische Substrat gedruckte Metallisierung wurde unter einer Schutzgasatmosphäre, bestehend aus 25% Wasserstoff und 75% Stickstoff bei einer Temperatur von 1450 °C über einen Zeitraum von 75 Minuten eingebrannt, wobei das Substrat auf einem Molybdänblech lag. Im Temperaturbereich zwischen 800 °C und 1050 °C wurde beim Aufheizen ein Taupunkt von 308 K eingestellt. Außerhalb dieses Temperaturintervalls entsprach der Wasserdampfgehalt der Aünosphäre einem Taupunkt von 265 K.

Nach dem Einbrennen der Metallisierungspaste wurde das metallisierte Substrat stromlos in einem handelsüblichen Nickelbad mit Hypophosphit als Reduktionsmittel vernickelt und sodann in einem Austauschgoldbad vergoldet. Die Schichtstärke des Nickels betrug 3,5 µm, die Stärke der Goldschicht 0,2 µm.

Der nach dem obigen Verfahren bestimmte Abreißwert wurde zu 3,8 kN/cm² gemessen. Derartig metallisierte Substrate finden besondere Anwendung in der Großserienfertigung von elektronischen Komponenten, die mit Hilfe eines Weichlots auf das metallbeschichtete, metallisierte Substrat gelötet werden können.

### Beispiel 2

In Abänderung des in Beispiel 1 beschriebenen Verfahrens wurde nach dem Vernickeln eine Legierungsschicht aus Blei-Zinn, vorzugsweise Sn63Pb37, von 15 µm Stärke kathodisch in einer Galvanisiertrommel abgeschieden. Der ermittelte Abreißwert war der gleiche wie in Beispiel 1. Solche metallisierten und mit Weichlotschicht versehenen Substrate können in der Kleinserienfertigung ohne Zuhilfenahme einer Lötstation unter Erwärmung auf mindestens 183 °C mit Bauteilen bestückt werden.

### Beispiel 3

Auf ein gebranntes Substrat aus Aluminiumnitrid mit 5 Gew.-% Aluminiumoxid sowie mit 3 Gew.-% Yttriumoxid als Sinterhilfe wurde eine Metallisierungspaste aufgetragen. Bei diesem Substrat liegen diskrete Teilchen von Aluminiumoxid in einer Matrix aus Aluminiumnitrid verteilt vor. Die Zusammensetzung der Metallisierungspaste sowie die Verarbeitungsparameter waren analog Beispiel 1. Die Aluminiumoxid-Körner wiesen ein Größe von 2 µm auf. Als Abreißwert wurden 3,9 kN/cm² ermittelt.

Da bei solchen Substraten die Wärmeleitfähigkeit in Abhängigkeit von dem Gehalt an Aluminiumoxid im Substrat um 50 - 80 % im Vergleich mit Keramiken aus reinem Aluminiumnitrid herabgesetzt sein können, lassen sich solche Substrate zur Erzeugung definierter Temperaturen auf der Substratoberfläche verwenden.

### Beispiel 4

In Abänderung des Beispiels 1 wurde eine Metallisierungspaste mit einem Glas der Zusammensetzung 39,2 Gew.-% MnO, 1,8 Gew.-% Al₂O₃, 47,1 Gew.-% SiO₂, 2 Gew.-% CaO, 0,3 Gew.-% TiO₂, Rest Alkalimetalloxide, Erdalkalimetalloxide, Eisenoxid jeweils < 1 Gew.-% auf ein Aluminiumnitrid-Keramik-Substrat in einer Schichtdicke von 25 µm aufgetragen und mit den gleichen Verfahrensparametern wie in Beispiel 1 eingebrannt. Anschließend wurde eine Nickel- und Goldschicht gemäß Beispiel 1 aufgalvanisiert. Der Abreißwert wurde zu 3,8 kN/cm² ermittelt.

## Patentansprüche

1. Verfahren zur Herstellung eines metallbeschichteten, metallisierten Bauteils aus Aluminiumnitridkeramik in den Schritten:
- Zubereitung einer Metallisierungspaste, enthaltend ein pulvriges Glas des MnO-Al₂O₃-SiO₂-Systems und ein Refraktärmetallpulver,
- Auftragen der Metallisierungspaste auf die Bauteiloberfläche,
- Ausbrennen des mit Metallisierungspaste beschichteten Bauteils bei einer Temperatur > 1100 °C unter reduzierter Feuchtgasatmosphäre aus wasserstoffhaltigem Stickstoff,
- Metallbeschichtung des metallisierten Bauteils mittels Galvanisierung,
dadurch gekennzeichnet, daß während des Aufheizens des mit Metallisierungspaste beschichteten keramischen Bauteils die Atmosphäre mit Wasserdampf so angefeuchtet wird, daß der Wasserdampfgehalt im Temperaturintervall zwischen 800 °C und
1050 °C einem Taupunkt von > 295 K entspricht und der Wasserdampfgehalt außerhalb dieses Temperaturintervalls einem Taupunkt von < 295 K entspricht.

2. Verfahren nach Anspruch 1, dadurch gekennzeichnet, daß die Metallisierungspaste bei Temperaturen zwischen 1100 °C und 1600 °C eingebrannt wird.

3. Verfahren nach Anspruch 2, dadurch gekennzeichnet, daß die Metallisierungspaste über einen Zeitraum von 30 - 120 Minuten eingebrannt wird.

4. Verfahren nach einem der vorhergehenden Ansprüche, dadurch gekennzeichnet, daß als Glaskomponente für die Metallisierungspaste ein Glas der Zusammensetzung
MnO 30 - 50 Gew.-%
SiO₂ 30 - 60 Gew. %
Al₂O₃ 3 - 15 Gew.-%
TiO₂ 0 - 2 Gew.-%, insbesondere mit 0,2 - 1,6 Gew.-% TiO_{2,}
verwendet wird.

5. Verfahren nach einem der vorhergehenden Ansprüche, dadurch gekennzeichnet, daß als Metallkomponente für die Metallisierungspaste Wolframpulver oder/und Molybdänpulver verwendet wird.

6. Verfahren nach einem der vorhergehenden Ansprüche, dadurch gekennzeichnet, daß zur Herstellung der Metallisierungspaste ein in einem organischen Lösungsmittel gelöstes organisches Harz, ein in Terpineol gelöstes Polyvinylbutyralharz oder Acrylharz oder/und ein Siebdrucköl zugesetzt wird.

7. Verfahren nach Anspruch 6, dadurch gekennzeichnet, daß als Siebdrucköl eine Lösung von Ethylcellulose in Terpineol zugesetzt wird.

8. Verfahren nach Anspruch 6, dadurch gekennzeichnet, daß zur Metallisierungspaste 0,1 - 5 Gew.-% Polyvinylbutyralharz zugesetzt werden.

9. Verfahren nach einem der vorhergehenden Ansprüche, dadurch gekennzeichnet, daß für die Metallisierungspaste ein Glaspulver mit mittlerer Korngröße von 2 - 15 µm oder/und ein Metallpulver mit der Korngröße von 1 - 4 µm verwendet wird.

10. Verfahren nach einem der vorhergehenden Ansprüche, dadurch gekennzeichnet, daß eine Metallisierungspaste mit einem Gewichtsverhältnis von Glaspulver zu Metallpulver von 1 : 19 bis 6 : 14 verwendet wird.

11. Verfahren nach einem der vorhergehenden Ansprüche, dadurch gekennzeichnet, daß die Metallisierungspaste mit einer Viskosität von 50-100 Pa · s mittels Siebdrucktechnik oder mittels Eintauchens des Bauteils in eine Metallisierungspaste mit einer Viskosität von < 5 Pa · s auf das Bauteil aufgebracht wird.

12. Verfahren nach einem der vorhergehenden Ansprüche, dadurch gekennzeichnet, daß die Metallisierungspaste mit einer Dicke von 10 - 50 µm aufgetragen wird.

13. Verfahren nach einem der vorhergehenden Ansprüche, dadurch gekennzeichnet, daß auf das metallisierte Bauteil eine Schicht aus Nickel und gegebenenfalls zusätzlich eine weitere Schicht aus Gold aufgebracht wird.

14. Verfahren nach Anspruch 13, dadurch gekennzeichnet, daß das Aufgalvanisieren der Nickel- und Goldschichten ohne Anlegen einer äußeren Stromquelle erfolgt.

15. Verfahren nach Anspruch 13, dadurch gekennzeichnet, daß das Aufgalvanisieren der Nickel- und Goldschichten kathodisch erfolgt.

16. Verfahren nach Anspruch 13, dadurch gekennzeichnet, daß eine weitere Lotschicht aus Pb-Sn kathodisch aufgebracht wird.

17. Metallisierungspaste zur Durchführung des Verfahrens nach einem der Ansprüche 1 - 4, dadurch gekennzeichnet, daß sie einen Haftvermittler aus Glaspulver mit einer mittleren Korngröße von 2 - 15 µm, ein Refraktärmetallpulver mit einer mittleren Korngröße von 1-4 µm sowie ein in einem geeigneten Lösungsmittel gelöstes organisches Harz oder/und ein Siebdrucköl enthält und daß sie für das Auftragen auf das Bauteil mittels Siebdrucktechnik eine Viskosität von 50 - 100 Pa · s und für das Auftragen durch Eintauchen eine Viskosität von < 5 Pa · s aufweist.

18. Metallisierungspaste nach Anspruch 17, dadurch gekennzeichnet, daß das Glaspulver eine mittlere Korngröße von 8 µm aufweist und daß das Metallpulver aus Wolfram oder/und Molybdän besteht.

19. Metallisierungspaste nach Anspruch 17 oder 18, dadurch gekennzeichnet, daß das Gewichtsverhältnis von Glas- und Metallpulver 1 : 19 bis 6 : 14 beträgt.

20. Mit der Metallisierungspaste nach Anspruch 17 oder 18 metallisiertes Bauteil aus Aluminiumnitrid mit aufgalvanisierten Metallschichten, hergestellt nach einem der Ansprüche 1 - 4 und 11, dadurch gekennzeichnet, daß die aufgetragenen Metallschichten eine Haftfestigkeit aufweisen, welche durch mittlere Abreißwerte von ≧ 3,5 kN/cm² gekennzeichnet sind.

21. Metallisiertes Bauteil aus Alumiumnitrid mit aufgalvanisierten Metallschichten nach Anspruch 20, dadurch gekennzeichnet, daß die aufgetragenen Schichten aus einer Nickelschicht und einer Goldschicht bestehen und Abreißwerte im Bereich von 3,8 +/- 0,6 kN/cm² aufweisen.

22. Metallisiertes Baute aus Aluminiumnitrid mit aufgalvanisierten Metallschichten nach Anspruch 20, dadurch gekennzeichnet, daß die Metallschichten aus einer Nickelschicht und einer Legierungsschicht aus Sn63Pb37 bestehen und Abreißwerte im Bereich von 3,8 +/- 0,6 N/cm² aufweisen.
